# EUROPEAN PATENT APPLICATION

(11) **EP 4 807 717 A1**
(43) Date of publication of application: **16.09.2026**
(21) Application number: 23958369.3
(22) Date of filing: 07.11.2023
(51) Int. Cl.: G09F 9/30, G06F 1/16, B60K 35/00

(54) **DISPLAY DEVICE**

(71) Applicant: LG Electronics Inc., Yeongdeungpo-gu Seoul 07336 (KR)
(72) Inventor: KWON, Boan, Seoul 06772 (KR); YOON, Hyunjin, Seoul 06772 (KR); KIM, Dongeun, Seoul 06772 (KR)
(74) Representative: Vossius & Partner Patentanwälte Rechtsanwälte mbB
(86) International application number: PCT/KR2023/017715
(87) International publication number: WO 2025/100568

(57) **Abstract**

A display device is disclosed. The display device of the present disclosure may include: an elongated plate; a display panel facing downward the plate and coupled to the plate to be movable in a longitudinal direction of the plate; and a hinge which crosses the display unit in a direction intersecting the moving direction of the display panel, wherein the display panel may be foldable about the hinge.

## Description

### TECHNICAL FIELD

The present disclosure relates to a display device. More particularly, the display device of the present disclosure relates to a display device for vehicle.

### BACKGROUND ART

As the information society develops, the demand for display devices is increasing in various forms. In response to this, recently, various display devices such as Liquid Crystal Display Device (LCD), Plasma Display Panel (PDP), Electro luminescent Display (ELD), Vacuum Fluorescent Display (VFD), and Organic Light Emitting Diode (OLED) have been researched and used. A display device using an organic light emitting diode (OLED) has the advantage of superior brightness and viewing angle compared to a liquid crystal display device, and can be implemented in an ultra-thin shape as it does not require a backlight unit.

A vehicle refers to a means of transport that moves under the control of a driver. A driver needs information related to vehicle's status to operate a vehicle, and the vehicle presents information related to vehicle's status to the driver through analog display devices or digital displays. As vehicle functions and performance improve, more information can be presented to a driver than before, and research has been conducted on displays for providing safe and space-efficient information due to a structure of vehicle which is constrained by passenger safety and space limitations.

Recently, self-driving vehicles capable of driving on their own without driver intervention have been developed. Inside a self-driving vehicle, a driver or passenger can receive information necessary for operating a vehicle, as well as information for work or convenience. In-vehicle infotainment (IVI) refers to a service implemented by devices that are installed inside a vehicle and provide entertainment for users, as well as driving-related information, such as vehicle status and navigation. In-car entertainment (ICE) refers to providing media for users inside the vehicle.

Recently, extensive research has been conducted on such vehicle display devices.

### DETAILED DESCRIPTION OF INVENTION

### TECHNICAL PROBLEMS

An object of the present disclosure is to solve the aforementioned problems and other problems.

Another object may be to provide a display device mounted on a ceiling of a vehicle.

Another object may be to provide a structure that can adjust the position and folding angle of a display panel.

Another object may be to provide a display device capable of adjusting the folding angle and position to easily provide various experiences for the passengers of the vehicle.

Another object may be to provide various examples of situation or condition for automatically adjusting the position and folding angle of a display panel.

### TECHNICAL SOLUTION

According to an aspect of the present disclosure for achieving the above or other objects, a display device may include: an elongated plate; a display panel facing downward from the plate, and coupled to the plate to be movable in a longitudinal direction of the plate; and a hinge which crosses a display unit in a direction intersecting with a moving direction of the display panel, wherein the display panel may be foldable around the hinge.

A vehicle may include the display device.

### EFFECT OF INVENTION

The effects of the display device according to the present disclosure are described as follows.

According to at least one of the embodiments of the present disclosure, there may be provided a display device mounted on a ceiling of a vehicle.

According to at least one of the embodiments of the present disclosure, there may be provided a structure that can adjust the position and folding angle of a display panel.

According to at least one of the embodiments of the present disclosure, there may be provided a display device capable of adjusting the folding angle and position to easily provide various experiences for the passengers of the vehicle.

According to at least one of the embodiments of the present disclosure, there may be provided various examples of situation or condition for automatically adjusting the position and folding angle of a display panel.

Further scope of the applicability of the present disclosure will become apparent from the following detailed description. However, since various changes and modifications within the spirit and scope of the present disclosure are clearly understood by those skilled in the art, specific embodiments such as the detailed description and preferred embodiments of the present disclosure should be understood as being given merely as examples.

### BRIEF DESCRIPTION OF THE DRAWING

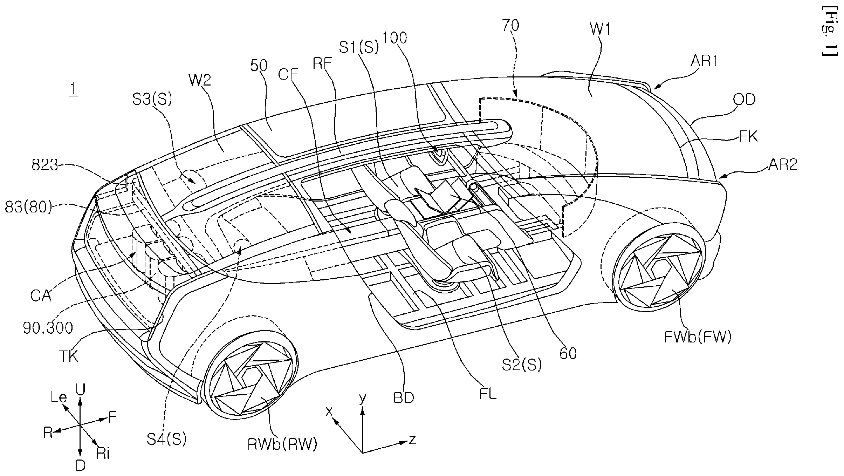

FIGS. 1 to 23 are drawings illustrating examples of a display device according to embodiments of the present disclosure.

### MODE FOR CARRYING OUT THE INVENTION

In the following description, the same or similar components are assigned the same reference numbers, and overlapping descriptions with respect to the same reference numbers may be omitted.

In the following description, suffixes such as "module" and "unit" may be used to refer to elements or components. Use of such suffixes herein is merely intended to facilitate description of the specification, and the suffixes do not have any special meaning or function.

In the following description, when it is determined that a detailed description of a well-known technology may obscure the gist of an embodiment of the present disclosure, a detailed description of the well-known technology may be omitted. In the following description, the accompanying drawings are used to assist in easy understanding of various technical features and it should be understood that the embodiments presented herein are not limited by the accompanying drawings. As such, the present disclosure should be construed to extend to any alterations, equivalents and substitutes in addition to those which are particularly set out in the accompanying drawings.

Terms such as first and second used in the following description may be used. These terms are only for distinguishing the elements from other elements, and the essence, sequence, or order of the elements are not limited by the terms.

It will be understood that when an element is referred to as being "connected with" another element, there may be intervening elements present. In contrast, it will be understood that when an element is referred to as being "directly connected with" another element, there are no intervening elements present.

A singular representation may include a plural representation unless context clearly indicates otherwise.

In the present application, it should be understood that the terms "comprises, includes," "has," etc. specify the presence of features, numbers, steps, operations, elements, components, or combinations thereof described in the specification, but do not preclude the presence or addition of one or more other features, numbers, steps, operations, elements, components, or combinations thereof.

The direction indications of up (U, y), down D, left (Le, x), right Ri, front (F, z) and rear R shown in the drawings are only for the convenience of explanation, and the technical concepts disclosed in this specification are not limited thereby.

Referring to FIG. 1, a vehicle 1 may use gasoline, diesel, gas, electricity, or hydrogen as fuel. The vehicle 1 may be able to perform a self-driving.

A frame FL may form a floor of the vehicle 1. A body BD that constitutes a roof and side panel of the vehicle 1 may be assembled to the frame FL or formed as one body with the frame FL. The frame FL may be referred to as a floor FL.

A chassis may be assembled to the frame FL. The chassis may include a power unit, such as an engine using fossil fuels as an energy source or a motor using electricity as an energy source, a power train system, a suspension system, a steering system such as a steering wheel 100, a brake system, and wheels FW, RW. The wheels FW, RW may include tires.

For example, a pair of front wheels FW may be mounted on the left and right sides of the frame FL while being adjacent to the front end of the frame FL. For example, a pair of rear wheels RW may be mounted on the left and right sides of the frame FL while being adjacent to the rear end of the frame FL.

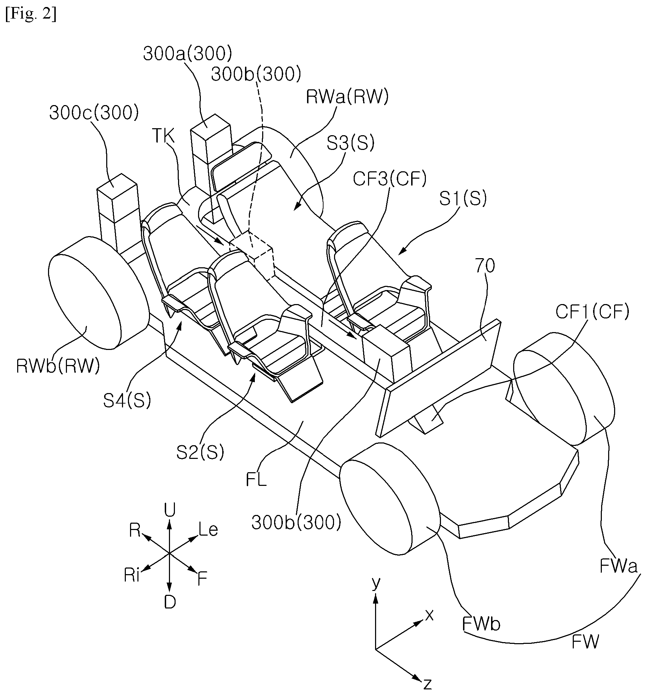

Referring to FIG. 2, a central frame CF may include a support portion CF3 and a fixed portion CF1. The support portion CF3 may be extended forward and rearward while being adjacent to the center of the frame FL. The fixed portion CF1 may be bent toward the frame FL from one end or both ends of the support portion CF3, and may be fixed to the frame FL.

A seat S may be disposed in the internal space of the vehicle 1 formed by the frame FL and a body BD. The seat S may be mounted on the central frame CF that crosses the center of the frame FL. There may be one or more seats S. The seats S may be opposite to each other with respect to the central frame CF. The length and/or angle of the seat S may be freely adjustable. The seat S may be moved along the central frame CF, and the seat S may be rotated around a vertical axis. That is, the seat S may face forward or rearward, and a passenger seated in the seat S may look forward or rearward.

A first seat S1 and a second seat S2 may be adjacent to a front portion of the central frame CF, and may be coupled to the left and right sides of the central frame CF. The first seat S1 and the second seat S2 may be referred to as first row seats S1, S2 or front seats S1, S2. The first seat S1 may be referred to as a driver's seat S1, and the second seat S2 may be referred to as a passenger seat S2.

A third seat S3 and a fourth seat S4 may be adjacent to a rear portion of the central frame CF, and may be coupled to the left and right sides of the central frame CF. The third seat S3 and the fourth seat S4 may be referred to as second row seats S3, S4 or back seats S3, S4.

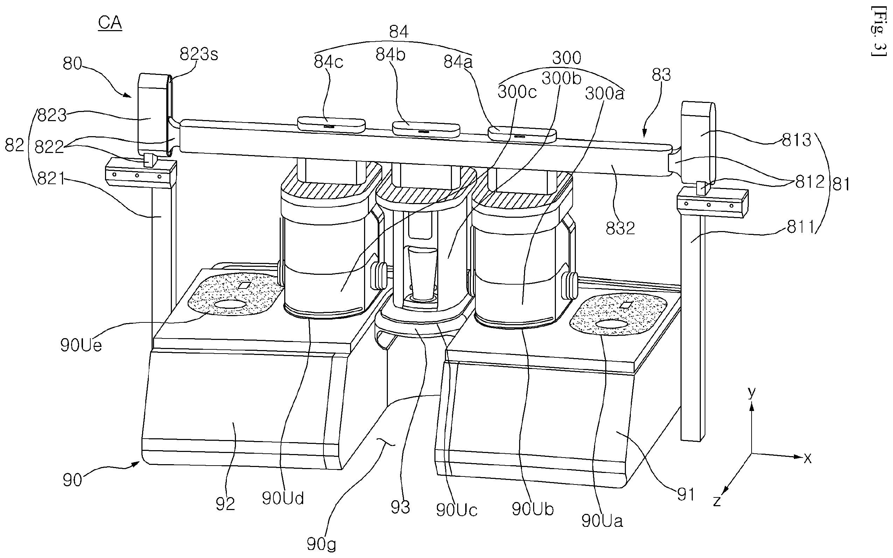

Referring to FIG. 3, an electronic device CA may include a crane 80, a tray 90, and an object 300. The electronic device CA may be referred to as a claw machine CA, a car appliance CA, or a concierge appliance CA. The object 300 may be referred to as a thing 300, a component 300, or a container 300.

The crane 80 may have an overall gantry crane shape. The crane 80 may include a first column 81, a second column 82, a bridge 83, and a carriage 84. For example, the second column 82 may be symmetrical to or identical to the first column 81. The carriage 84 may be referred to as a carrier 84.

The first column 81 may be extended vertically, and may form the left side of the crane 80. The first column 81 may include a first linear actuator 811, a first fixer 812, and a first guide 813. The first linear actuator 811 may be extended in the longitudinal direction (i.e., vertical direction) of the first column 81, and may form the lower end of the first column 81. The first fixer 812 may be fixed to the upper end of the first linear actuator 811. The first guide 813 may be coupled to the first linear actuator 811 through the first fixer 812, and may form the upper end of the first column 81.

The second column 82 may be extended vertically, and may form the right side of the crane 80. The second column 82 may include a second linear actuator 821, a second fixer 822, and a second guide 823. The second linear actuator 821 may be extended in the longitudinal direction (i.e., vertical direction) of the second column 82, and may form the lower end of the second column 82. The second fixer 822 may be fixed to the upper end of the second linear actuator 821. The second guide 823 may be coupled to the second linear actuator 821 through the second fixer 22, and may form the upper end of the second column 82.

The bridge 83 may be positioned between the first column 81 and the second column 82, and may connect the first column 81 and the second column 82. The bridge 83 may form the upper side of the crane 80. The bridge 83 may have the shape of a bar or girder that extends horizontally. The left distal end of the bridge 83 may be adjacent to the upper portion of the first column 81, and may be fixed to the first fixer 812. The right distal end of the bridge 83 may be adjacent to the upper portion of the second column 82, and may be fixed to the second fixer 822.

The carriage 84 may be coupled to the bridge 83, and may protrude downward from the bridge 83. The carriage 84 may be suspended from the bridge 83. The number of carriages 84 may be one or more. A plurality of carriages 84a, 84b, 84c may be arranged along the longitudinal direction of the bridge 83.

The tray 90 may be positioned below the bridge 83 of the crane 80, and positioned between the first and second columns 81, 82 of the crane 80. For example, the tray 90 may be positioned on the floor of the trunk TK of the vehicle 1 (see FIG. 1). The tray 90 may have an overall block shape. For example, the tray 90 may include a first part 91, a second part 92, and a third part 93. A groove 90g of the tray 90 may be formed between the first part 91 and the second part 92, and the third part 93 may cover at least a portion of the upper side of the groove 90g. The upper surface of the tray 90 may be flat.

An object 300 may be placed on the upper surface of the tray 90. The carriage 84 may face the object 300, and may be detachably coupled to the object 300. The number of objects 300 may be one or more. A plurality of objects 300a, 300b, 300c may be arranged along the longitudinal direction of the bridge 83. The number of objects 300 may be equal to or less than the number of carriages 84.

The types of object 300 can vary. For example, a first object 300a may be a game pad, a second object 300b may be a coffee machine, and a third object 300c may be a refrigerator. For example, the object 300 may be a beverage or champagne, an air purifier, a speaker, a lighting device, etc. The object 300 may be referred to as a thing, a component, or a container.

Referring to FIGS. 1 to 3, the electronic device CA may be disposed inside the trunk TK of the vehicle 1. Meanwhile, a user may remove the electronic device CA from the trunk TK, and load other item(s) into the trunk TK.

The first and second guides 813, 823 of the electronic device CA may be fixed to the body BD forming the boundary of the trunk TK. The lower ends of the first and second linear actuators 811, 821 of the electronic device CA may be fixed on the body BD or frame FL inside the body BD.

That is, when the length of the first and second linear actuators 811, 821 increases, the bridge 83 fixed to the first and second linear actuators 811, 821 through the first and second fixers 812, 823 may rise along the first and second guides 813, 823. In addition, when the length of the first and second linear actuators 811, 821 is shortened, the bridge 83 fixed to the first and second linear actuators 811, 821 through the first and second fixers 812, 823 may descend along the first and second guides 813, 823.

In response to the bridge 83 that rises or descends electrically, a plurality of objects 300a, 300b, 300c coupled to the bridge 83 through a plurality of carriages 84a, 84b, 84c may also rise upward from the tray 90 or descend toward the tray 90. In addition, a plurality of carriages 84a, 84b, 84c coupled with a plurality of objects 300a, 300b, 300c may move left and right along the bridge 83 electrically.

Accordingly, the electronic device CA may automatically change the position of a plurality of objects 300a, 300b, 300c seated on the tray 90.

For example, a first object 300a may be positioned in a second area 90Ub of the tray 90, a second object 300b may be positioned in a third area 90Uc of the tray 90, and a third object 300c may be positioned in a fourth area 90Ud of the tray 90. A first carriage 84a may be detachably coupled to the first object 300a, a second carriage 84b may be detachably coupled to the second object 300b, and a third carriage 84c may be detachably coupled to the third object 300c. The first to third carriages 84a, 84b, 84c may lift the first to third objects 300a, 300b, 300c from the tray 90, and then place them on first to third areas 90Ua, 90Ub, 90Uc of the tray 90. Alternatively, the first to third carriages 84a, 84b, 84c may lift the first to third objects 300a, 300b, 300c from the tray 90, and then place them on the third to fifth areas 90Uc, 90Ud, 90Ue of the tray 90.

The third area 90Uc of the tray 90 may be referred to as a central area 90Uc or a reference area 90Uc. The object 300 positioned in the reference area 90Uc may be provided from the trunk TK to a passenger space where the seats S are positioned. The type of object 300 positioned in the reference area 90Uc may be changed by a position change mechanism of the aforementioned objects. Such a change in the type of object 300 may be in response to a passenger's request.

For example, a passenger may bring the object 300 positioned in the reference area 90Uc into a passenger space through an opening formed in the inner wall of the trunk TK.

As another example, a transport means, such as a sliding shuttle or conveyor belt installed in the central frame CF, may provide the object 300 positioned in the reference area 90Uc to a passenger. The central frame CF may be extended forward and rearward between the left seats S1, S3 and the right seats S2, S4, and the object 300 may be moved along the central frame CF by the transport means. The third part 93 of the tray 90 forming the reference area 90Uc may constitute the transport means. The third part 93 may be separated from the first and second parts 91, 92 of the tray 90, and may move along the central frame CF.

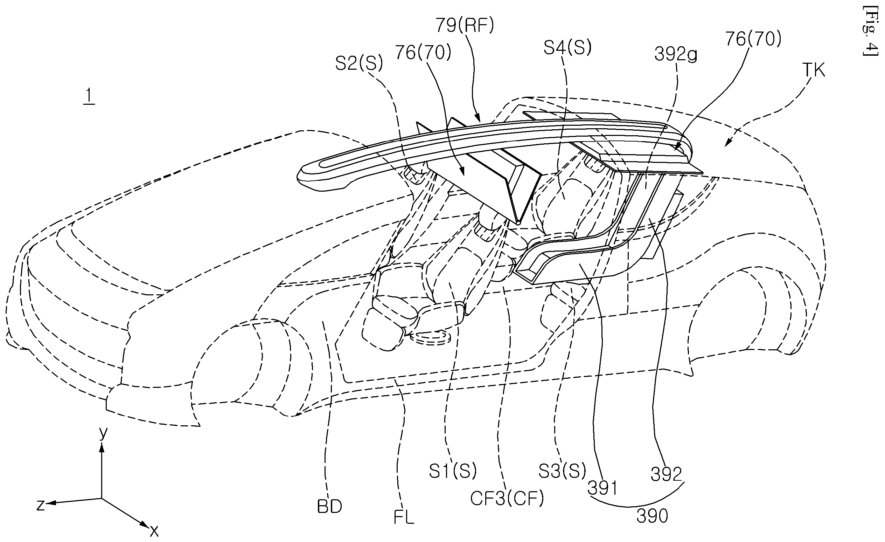

Referring to FIG. 4, a top frame RF may form a portion of the top of the vehicle 1, and may be extended long in the front-rear direction. The top frame RF may be extended along the top of the vehicle 1, and may be curved or straight. The left door 50 (see FIG. 1) may be hinge-movably connected to the body BD on the left side of the top frame RF, and the right door may be hinge-movably connected to the body BD on the right side of the top frame RF.

A gate assembly 390 may be mounted in the passenger space of the vehicle 1 where the seats S are disposed, and may be adjacent to the trunk TK of the vehicle 1. The gate assembly 390 may be disposed between the rear seats S3, S4. The gate assembly 390 may include a base module 391 and a gate module 392. The base module 391 may be extended along the support portion CF3 of the central frame CF, and may be connected to the rear portion of the support portion CF3. The gate module 392 may be bent from the base module 391 toward the top frame RF. When a gate 392g of the gate module 392 is opened, the passenger space of the vehicle 1 and the internal space of the trunk TK may be interconnected, and when the gate 392g is closed, the passenger space of the vehicle 1 and the internal space of the trunk TK may not be interconnected.

Accordingly, a transport means such as the third part 93 carrying the object 300 positioned in the reference area 90Uc may be provided from the trunk TK to the passenger space of the vehicle 1 or moved from the passenger space to the trunk TK through the gate 392g of the gate module 392 (see FIG. 1 to 3).

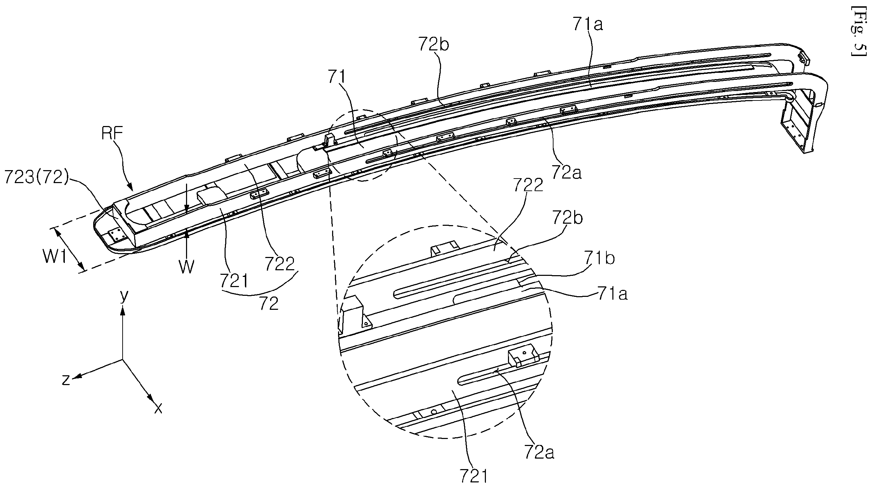

Referring to FIGS. 4 and 5, the top frame RF may include a plate 71, an outer rail 72, and a cover 79. The plate 71, the outer rail 72, and the cover 79 may be extended along the top of the vehicle 1, and may be curved or straight. The outer rail 72 may be referred to as a first guide rail 72.

The plate 71 may be extended, and form the bottom of the top frame RF. The plate 71 may be referred to as a base 71. A rack 71a may be extended along the plate 71, and may be fixed to the upper surface of the plate 71 or formed as one body with the plate 71. The length of the rack 71a may be shorter than the length of the plate 71. A slot 71b may be formed to penetrate the plate 71 in the thickness direction of the plate 71, and may be formed along the plate 71. The slot 71b may be adjacent to the rack 71a.

An outer rail 72 may be extended along the plate 71, and may be fixed to the upper surface of the plate 71. The width direction of the outer rail 72 (see width W2 of the outer rail 72) may intersect with the width direction of the plate 71 (see width W1 of the plate 71). A portion of the outer rail 72 may be bent downward from the rear end of the remaining portion of the outer rail 72, and may be connected to the gate assembly 390. The outer rail 72 may include a first outer part 721, a second outer part 722, and a third outer part 723.

The first outer part 721 may be extended along the left side of the plate 71, and may form the left side of the outer rail 72. A first outer slot 72a may be formed to penetrate the first outer part 721 in the thickness direction of the first outer part 721, and may be formed long in the longitudinal direction of the first outer part 721.

The second outer part 722 may be extended along the right side of the plate 71, and may form the right side of the outer rail 72. A second outer slot 72b may be formed to penetrate the second outer part 722 in the thickness direction of the second outer part 722, and may be formed long in the longitudinal direction of the second outer part 722.

In the width direction of the plate 71, the first outer part 721 and the second outer part 722 may be spaced apart from each other, and the third outer part 723 may connect the front end of the first outer part 721 and the front end of the second outer part 722.

The cover 79 (see FIG. 4) may be opposite to the plate 71 with respect to the outer rail 72, and may be coupled to the plate 71. The cover 79 may cover the plate 71 and the outer rail 72, and may form the top of the top frame RF. The internal space of the top frame RF may be formed between the plate 71 and the cover 79.

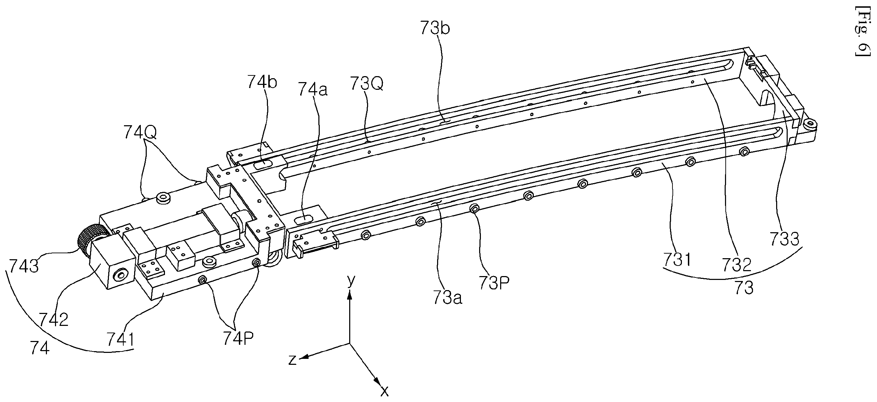

Referring to FIG. 6, an inner rail 73 may be extended along the plate 71, (see FIG. 5), and may be positioned on or adjacent to the upper surface of the plate 71. The length of the inner rail 73 may be shorter than the length of the outer rail 72. The inner rail 73 may include a first inner part 731, a second inner part 732, and a third inner part 733.

The first inner part 731 may be extended along the first outer part 721 (see FIG. 5) of the outer rail 72, and may face the inner surface of the first outer part 721. A first inner slot 73a may be formed to penetrate the first inner part 731 in the thickness direction of the first inner part 731, and may be formed long in the longitudinal direction of the first inner part 731. A first inner pin 73P may protrude from the outer surface of the first inner part 731 toward a first outer slot 72a (see FIG. 5) of the first outer part 721, and may be movably inserted into the first outer slot 72a. The first inner pin 73P may be a protrusion or a roller. A plurality of first inner pins 73P may be spaced apart from each other along the first inner part 731.

The second inner part 732 may be extended along the second outer part 722 (see FIG. 5) of the outer rail 72, and may face the inner surface of the second outer part 722. A second inner slot 73b may be formed to penetrate the second inner part 732 in the thickness direction of the second inner part 732, and may be formed long in the longitudinal direction of the second inner part 732. A second inner pin 73Q may protrude from the outer surface of the second inner part 732 toward the second outer slot 72b (see FIG. 5) of the second outer part 722, and may be movably inserted into the second outer slot 72b. The second inner pin 73Q may be a protrusion or a roller. A plurality of second inner pins 73Q may be spaced apart from each other along the second inner part 732.

In the width direction of the plate 71, (see FIG. 5), the first inner part 731 and the second inner part 732 may be spaced apart from each other, and the third inner part 733 may connect the rear end of the first inner part 731 and the rear end of the second inner part 732.

A first carrier 74 may be positioned in front of the inner rail 73, and may be coupled to the inner rail 73. The first carrier 74 may be fixed to the front end of the first inner part 731 and the front end of the second inner part 732. The first carrier 74 may be referred to as a front carrier 74, a first carriage 74, a first slider 74, or a first moving body 74. The first carrier 74 may include a first body 741, a first motor 742, and a first pinion 743.

The first body 741 may have an overall flat block shape, and may be mounted between the first inner part 731 and the second inner part 732. The first body 741 may be referred to as a first bracket 741. A first front pin 74P may protrude from the left side surface of the first body 741 toward the first outer slot 72a (see FIG. 5) of the first outer part 721, and may be movably inserted into the first outer slot 72a. The first front pin 74P may be a protrusion or a roller. A plurality of first front pins 74P may be spaced apart from each other along the left side of the first body 741. A second front pin 74Q may protrude from the right side surface of the first body 741 toward the second outer slot 72b, see FIG. 5 of the second outer part 722 and may be movably inserted into the second outer slot 72b. The second front pin 74Q may be a protrusion or a roller. A plurality of second front pins 74Q may be spaced apart from each other along the right side of the first body 741.

The first motor 742 may be mounted on the front end of the first body 741. The first motor 742 may be an electric motor capable of adjusting the rotational direction, rotational speed, and rotational angle of a rotation axis.

The first pinion 743 may be fixed to the rotation axis of the first motor 742. The rotation center axis of the first pinion 743 may intersect with the longitudinal axis of the rack 71a (see FIG. 5). The rotation center axis of the first pinion 743 may be parallel to the left-right direction.

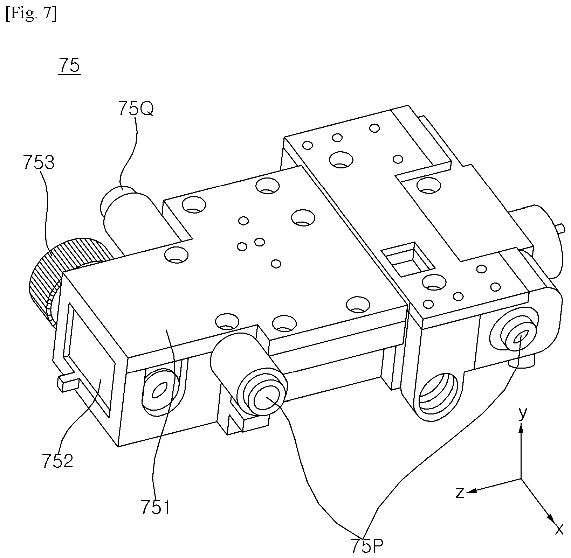

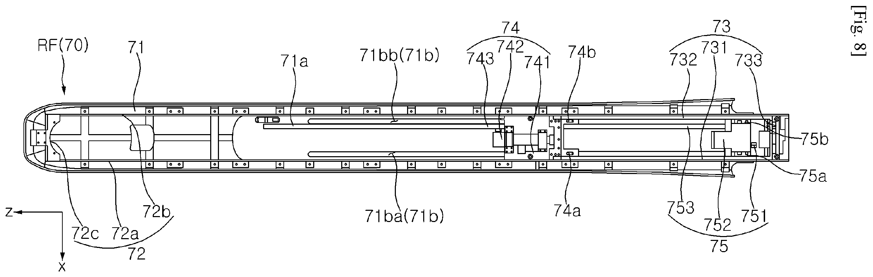

Referring to FIGS. 7 and 8, the second carrier 75 may be positioned at the rear of the first carrier 74, and may be positioned between the first inner part 731 and the second inner part 732. The second carrier 75 may be referred to as a second carriage 75, a second slider 75, or a second moving body 75. The second carrier 75 may include a second body 751, a second motor 752, and a second pinion 753.

The second body 751 may have an overall flat block shape, and may be positioned between the first inner part 731 and the second inner part 732. The second body 751 may be referred to as a second bracket 751. A first rear pin 75P may protrude from the left side surface of the second body 751 toward the first inner slot 73a (see FIG. 6) of the first inner part 731, and may be movably inserted into the first inner slot 73a. The first rear pin 75P may be a protrusion or a roller. A plurality of first rear pins 75P may be spaced apart from each other along the left side of the second body 751. A second rear pin 75Q may protrude from the right side surface of the second body 751 toward the second inner slot 73b (see FIG. 6) of the second inner part 732, and may be movably inserted into the second inner slot 73b. The second rear pin 75Q may be a protrusion or a roller. A plurality of second rear pins 75Q may be spaced apart from each other along the right side of the second body 751.

The second motor 752 may be mounted on the front end of the second body 751. The second motor 752 may be an electric motor capable of adjusting the rotational direction, rotational speed, and rotational angle of a rotation axis.

The second pinion 753 may be fixed to the rotation axis of the second motor 752. The rotation center axis of the second pinion 753 may be parallel to the rotation center axis of the first pinion 743 (see FIG. 6). The rotation center axis of the second pinion 753 may be parallel to the left-right direction.

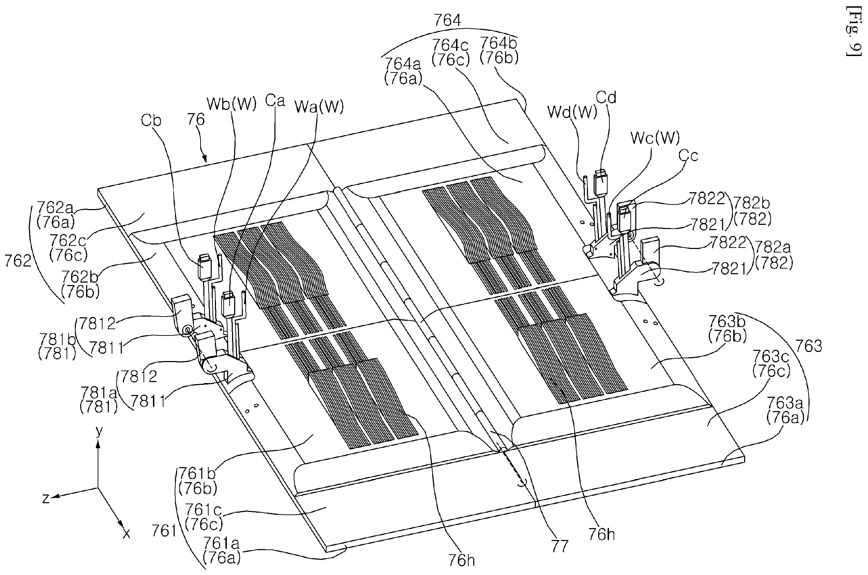

Referring to FIG. 9, the display device 70 may include a top frame RF, a display unit 76, a hinge 77, and a holder 78. As described above in FIG. 4 to 8, the top frame RF may include a plate 71, an outer rail 72, an inner rail 73, a first carrier 74, a second carrier 75, and a cover 79.

The display unit 76 may include a display panel 76a and a back cover 76b. The display panel 76a may display an image, and based on FIG. 9, an image may be displayed on the lower surface of the display panel 76a. The display panel 76a may be an LCD panel, an LED panel, or an OLED panel. The back cover 76b may be opposite to the display panel 76a, and may be coupled to the display panel 76a. A plate 76c may be coupled to the display panel 76a and the back cover 76b at between them, and the plate 76c may cover the upper surface of the display panel 76a. Electronic components may be mounted between the plate 76c and the back cover 76b, and may operate the display panel 76a. Heat dissipation holes 76h may be formed in the back cover 76b.

The display unit 76 may be composed of a plurality of display modules 761, 762, 763, 764. A first display module 761 may include a first display panel 761a and a first back cover 761b. A second display module 762 may be adjacent to the first display module 761, and may include a second display panel 762a and a second back cover 762b. A third display module 763 may be opposite to the first display module 761, and may include a third display panel 763a and a third back cover 763b. A fourth display module 764 may be adjacent to the third display module 763, and may include a fourth display panel 764a and a fourth back cover 764b.

The hinge 77 may be positioned between the first and second display modules 761, 762 and the third and fourth display modules 763, 764. The hinge 77 may be extended in the left-right direction, and may be positioned between the first and second back covers 761b, 762b and the third and fourth back covers 763b, 764b. One sides of the first and second display modules 761, 762 may be rotatably coupled to the hinge 77, and one sides of the third and fourth display modules 763, 764 may also be rotatably coupled to the hinge 77.

Accordingly, the display unit 76 may be folded or unfolded around the hinge 77. The rotation center axis of the hinge 77 may be parallel to the left-right direction. That is, the hinge 77 may provide a folding center axis for the display unit 76.

Alternatively, in addition to the two display modules 761, 762, one or more additional modules may be provided on one side (i.e., the front) of the hinge 77, and in addition to the two display modules 763, 764, one or more additional modules may be provided on the opposite side (i.e., the rear) of the hinge 77.

Alternatively, the first and second display modules 761, 762 may be replaced with a single display module, and the third and fourth display modules 763, 764 may be replaced with a single display module.

Alternatively, the display unit 76 may be composed of a single display module, and in this case, the flexible display panel 76a of the display unit 76 may be bent in response to the folding operation of the display unit 76.

The holder 78 may include a first holder 781 and a second holder 782.

The first holder 781 may include a first lower part 7811 and a first upper part 7812. The first lower part 7811 may be fixed to the back cover 76b of the display unit 76 while being adjacent to the front end of the display unit 76. The first upper part 7812 may be rotatably coupled to the first lower part 7811, and fixed to the first body 741 (see FIG. 6) of the first carrier 74. The rotation center axis of the first lower part 7811 may be parallel to the longitudinal axis of the hinge 77. A pair of first holders 781a, 781b may be spaced apart from each other, and may connect the display unit 76 and the first carrier 74 through a pair of slots 71ba, 71bb (see FIG. 8) formed in the plate 71.

The second holder 782 may include a second lower part 7821 and a second upper part 7822. The second lower part 7821 may be fixed to the back cover 76b of the display unit 76 while being adjacent to the rear end of the display unit 76. The second upper part 7822 may be rotatably coupled to the second lower part 7821, and be fixed to the second body 751 (see FIG. 7) of the second carrier 75. The rotation center axis of the second lower part 7821 may be parallel to the longitudinal axis of the hinge 77. A pair of second holders 782a, 782b may be spaced apart from each other, and may connect the display unit 76 and the second carrier 75 through a pair of slots 71ba, 71bb (see FIG. 8) formed in the plate 71.

A first connector Ca of the first display module 761 may be connected to the first carrier 74 through a first slot 71ba, and a first wire Wa of the first display module 761 may pass through the first slot 71ba and a first hole 74a of the first carrier 74 (see FIG. 8).

A second connector Cb of the second display module 762 may be connected to the first carrier 74 through a second slot 71bb, and a second wire Wb of the second display module 762 may pass through the second slot 71bb and a second hole 74b of the first carrier 74 (see FIG. 8).

A third connector Cc of the third display module 763 may be connected to the second carrier 75 through the first slot 71ba, and a third wire Wc of the third display module 763 may pass through the first slot 71ba and the first hole 75a of the second carrier 75 (see FIG. 8).

A fourth connector Cd of the fourth display module 764 may be connected to the second carrier 75 through the second slot 71bb, and a fourth wire Wd of the fourth display module 764 may pass through the second slot 71bb and the second hole 75b of the second carrier 75 (see FIG. 8).

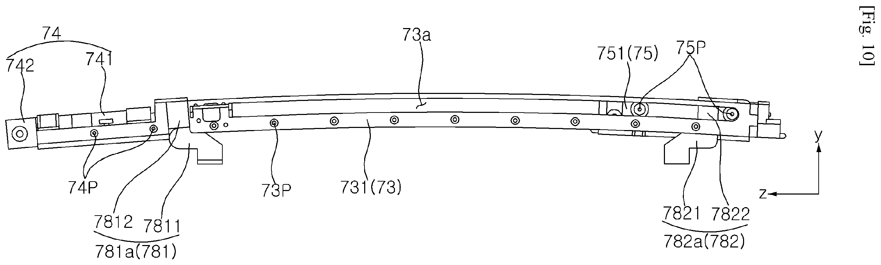

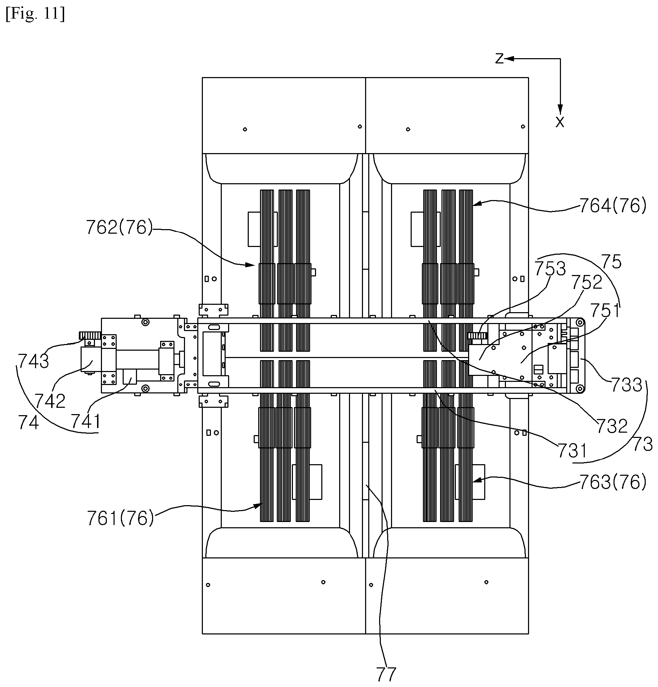

Referring to FIGS. 10 and 11, the first carrier 74 may be fixed to the front end of the inner rail 73, and the second carrier 75 may be positioned inside the inner rail 73 while being adjacent to the rear end of the inner rail 73. The distance between the first carrier 74 and the second carrier 75 may be the maximum distance. At this time, the display unit 76 may be in an unfolded state.

The first pinion 743 (see FIG. 6) of the first carrier 74 and the second pinion 753 (see FIG. 7) of the second carrier 75 may be engaged with the rack 71a (see FIG. 5) of the plate 71. The first pinion 743 and the second pinion 753 may share the rack 71a.

Accordingly, in response to the operation of the first motor 742, when the first pinion 743 (see FIG. 6) engaged with the rack 71a (see FIG. 5) rotates counterclockwise, the first carrier 74 and the inner rail 73 fixed to the first carrier 74 may move forward along the first and second outer slots 72a, 72b (see FIG. 5). In response to the operation of the first motor 742, when the first pinion 743 (see FIG. 6) engaged with the rack 71a (see FIG. 5) rotates clockwise, the first carrier 74 and the inner rail 73 fixed to the first carrier 74 may move rearward along the first and second outer slots 72a, 72b (see FIG. 5).

In addition, the second carrier 75 may move together with the first carrier 74 and the inner rail 73. To this end, the second pinion 753 (see FIG. 7) of the second carrier 75 engaged with the rack 71a (see FIG. 5) may be rotated in the same direction and speed as the first pinion 743 (see FIG. 6) of the first carrier 74. For example, the second motor 752 (see FIG. 7) of the second carrier 75 may be operated in sync with the first motor 742 (see FIG. 6) of the first carrier 74. As another example, the second pinion 753 (see FIG. 7) may be rotated in the same direction and speed as the first pinion 743 (see FIG. 6) without the intervention of the second motor 752 (see FIG. 7), in response to the movement of the first carrier 74 and the inner rail 73.

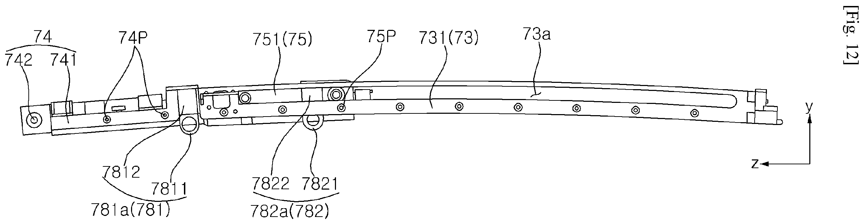

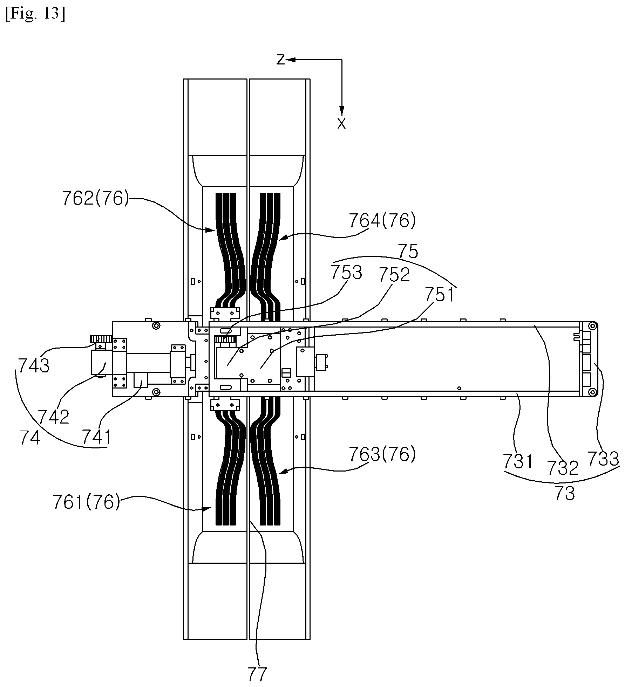

Referring to FIGS. 12 and 13, in response to the operation of the second motor 752 (see FIG. 7), when the second pinion 753 (see FIG. 7) engaged with the rack 71a (see FIG. 5) rotates counterclockwise, the second carrier 75 may move forward along the first and second inner slots 73a, 73b (see FIG. 6). In response to the operation of the second motor 752 (see FIG. 7), when the second pinion 753 (see FIG. 7) engaged with the rack 71a (see FIG. 5) rotates clockwise, the second carrier 75 may move rearward along the first and second inner slots 73a, 73b (see FIG. 6).

For example, the first motor 742 of the first carrier 74 may not be operated during the movement of the second carrier 75 described above. Accordingly, the second carrier 75 may move towards or away from the first carrier 74.

As another example, the first motor 742 of the first carrier 74 may also be operated during the movement of the second carrier 75 described above. In this case, when the first pinion 743 (see FIG. 6) of the first carrier 74 and the second pinion 753 (see FIG. 7) of the second carrier 75 rotate in the same direction, the rotational speed of the second pinion 753 may be faster than the rotational speed of the first pinion 743. Accordingly, the second carrier 75 may move towards or away from the first carrier 74.

As another example, the first motor 742 of the first carrier 74 may also be operated during the movement of the second carrier 75 described above. In this case, the first pinion 743 (see FIG. 6) of the first carrier 74 and the second pinion 753 (see FIG. 7) of the second carrier 75 may rotate in opposite directions. Accordingly, the second carrier 75 may move towards or away from the first carrier 74.

The display unit 76 may be positioned below the plate 71 (see FIG. 5), the front end of the display unit 76 may be rotatably coupled to the first carrier 74 through the first holder 781, and the rear end of the display unit 76 may be rotatably coupled to the second carrier 75 through the second holder 782.

Accordingly, as the second carrier 75 approaches the first carrier 74, the display unit 76 may be gradually folded, and as the second carrier 75 moves away from the first carrier 75, the display unit 76 may be gradually unfolded.

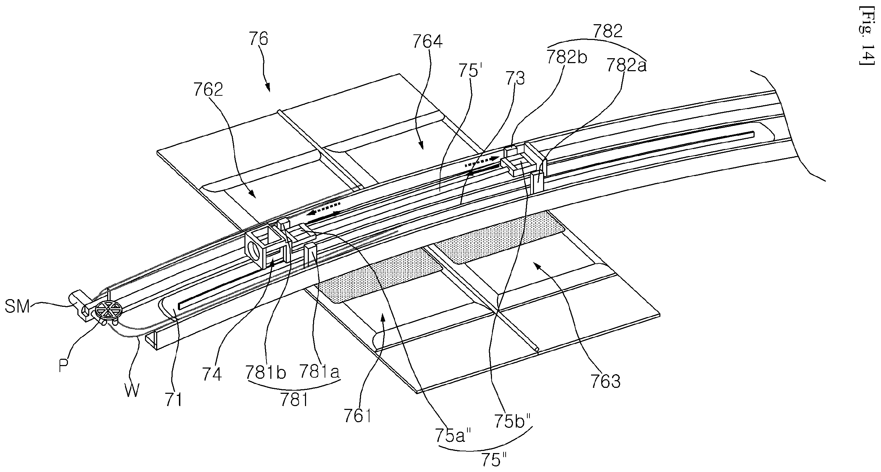

Referring to FIG. 14, the display device 70 may include a lead screw 75' and a pair of second carriers 75" in place of the aforementioned second carrier 75.

The lead screw 75' may be positioned inside the inner rail 73, and may be extended along the plate 71. The lead screw 75' may be connected to the rotation axis of the first motor 742 of the first carrier 74. For example, the rotation axis of the first motor 742 may be fixed to a worm parallel to the left-right direction, and a worm wheel engaged with the worm may rotate around an axis parallel to the lead screw 75'. In this case, the distal end of the lead screw 75' may be fixed to the worm wheel and rotated. Male screw threads may be formed on the outer surface of the lead screw 75'.

A second front carrier 75a" may have a hole through which the lead screw 75' passes, and may be movably coupled to the inner slots 73a, 73b (see FIG. 6) of the inner rail 73. Female screw threads may be formed on the inner surface of the hole of the second front carrier 75a". Thus, the second front carrier 75a" may reciprocate linearly along the lead screw 75' in response to the rotation of the lead screw 75'.

A second rear carrier 75b" may have a hole through which the lead screw 75' passes, and may be movably coupled to the inner slots 73a, 73b (see FIG. 6) of the inner rail 73. Female screw threads may be formed on the inner surface of the hole of the second rear carrier 75b". Accordingly, the second rear carrier 75b" may reciprocate linearly along the lead screw 75' in response to the rotation of the lead screw 75'.

A pair of first holders 781a, 781b may connect the display unit 76 and the second front carrier 75a". A pair of second holders 782a, 782b may connect the display unit 76 and the second rear carrier 75b". The first carrier 74 and the inner rail 73 may move along the plate 71 as described above.

When the lead screw 75' rotates in a first rotational direction, a pair of second carriers 75a" may move closer to each other along the lead screw 75' (see solid arrow). In this case, as the lead screw 75' rotates, the display unit 76 may be gradually folded.

When the lead screw 75' rotates in a second rotation direction opposite to the first rotation direction, a pair of second carriers 75a" may move away from each other along the lead screw 75' (see dotted arrow). In this case, as the lead screw 75' rotates, the display unit 76 may be gradually unfolded.

Meanwhile, a sunroof motor SM may provide power to a sunroof that opens or closes the roof of the vehicle 1. The sunroof motor SM, and the pulley P and cable W connected thereto may be mounted on the plate 71.

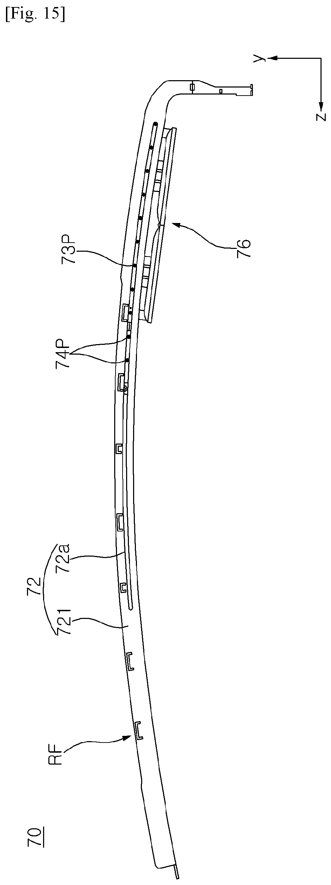

Referring to FIG. 15, the display unit 76 may be positioned at the rear portion of the outer rail 72, and the display unit 76 may be flat.

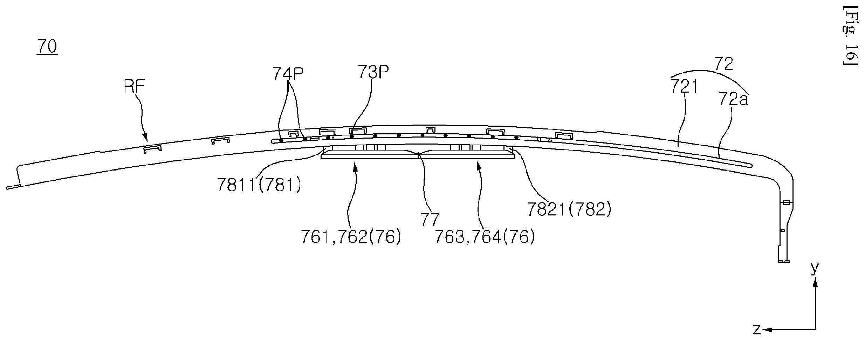

Referring to FIG. 16, the display unit 76 may be positioned at the center of the outer rail 72, and the display unit 76 may be flat. In this case, the display unit 76 may display an image downward.

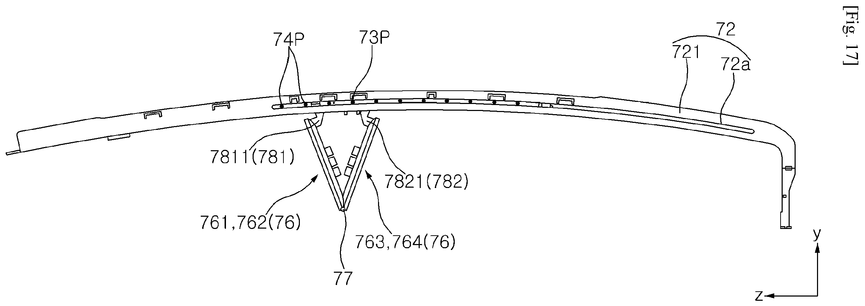

Referring to FIG. 17, the display unit 76 may be positioned at the center of the outer rail 72, and the display unit 76 may be folded in a "V" shape. In this case, a first portion 761, 762 of the display unit 76 may display an image forward, and a second portion 763, 764 of the display unit 76 may display an image rearward.

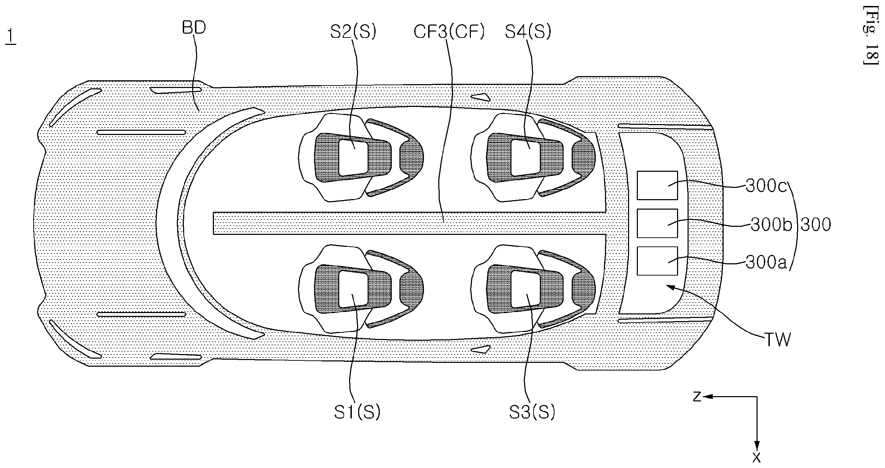

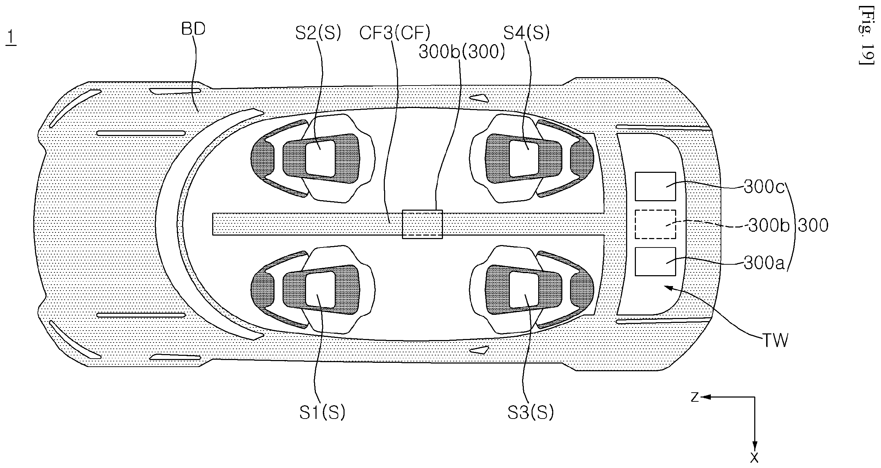

Referring to FIGS. 18 and 19, the seats S may face in various directions. Here, the direction in which the seat S faces may be the direction in which a passenger seated on the seat S looks.

Referring to FIG. 18, the first to fourth seats S1, S2, S3, S4 may face forward. The vehicle 1 of FIG. 17 may be referred to as a vehicle in drive mode. Accordingly, all passengers of the vehicle 1 may face forward.

Referring to FIG. 19, the first and second seats S1, S2 may face rearward, and the third and fourth seats S3, S4 may face forward. The vehicle 1 of FIG. 18 may be referred to as a vehicle in lounge mode. Accordingly, passengers seated in the first row seats S1, S2 and passengers seated in the second row seats S3, S4 may face each other.

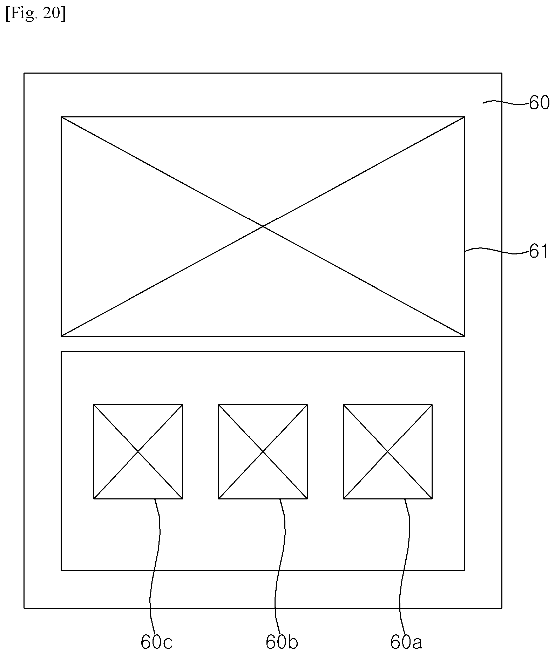

Referring to FIGS. 1 and 20, a control display panel 60 may be mounted on the central frame CF. A portion of the central frame CF may be an armrest for a passenger seated in the seat S, and the control display panel 60 may be mounted on the armrest. The passenger may view an image displayed on the control display panel 60. The control display panel 60 may be touch-sensitive, and the passenger may control the control display panel 60 and/or the vehicle 1 by touching the control display panel 60.

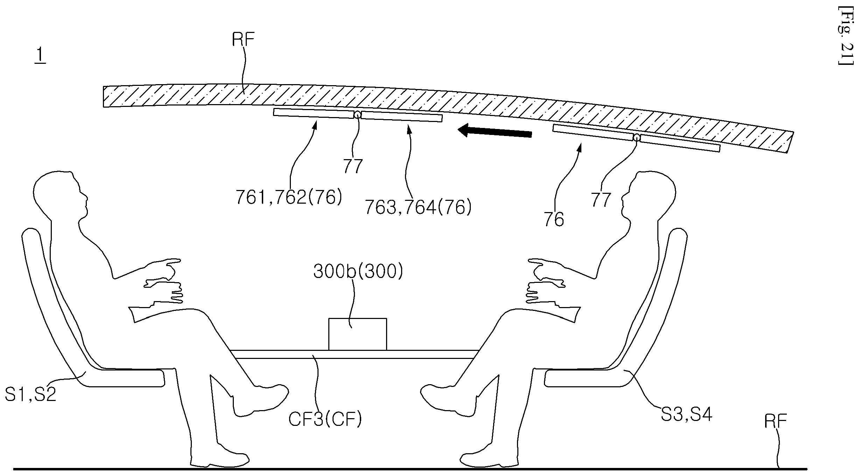

Referring to FIGS. 21 to 23, a passenger may adjust the position and angle of the display unit 76. For example, a passenger may adjust the position and angle of the display unit 76 through the control display panel 60. As another example, a passenger may adjust the position and angle of the display unit 76 through other interface device such as button, dial, or microphone.

The control display panel 60 may display icons of objects 300 (see FIG. 19) loaded in the trunk TK of the vehicle 1. A first icon 60a may correspond to a first object 300a, a second icon 60b may correspond to a second object 300b, and a third icon 60c may correspond to a third object 300c.

Referring to FIG. 21, a passenger of the lounge mode may touch the second icon 60b of the control display panel 60. In response to the touch of the second icon 60b, the second object 300b in the trunk TK may be provided to the passenger space by a transport means (see FIGS. 1 to 3) such as a third part 93 (see FIG. 19). For example, the second object 300b may be a coffee machine. In addition, in response to the touch of the second icon 60b, the display unit 76 may be moved to the center of the top frame RF. At this time, the display unit 76 may output images or videos in an unfolded state. Accordingly, passengers in the lounge mode can enjoy a cup of coffee and a chat in a relaxed setting.

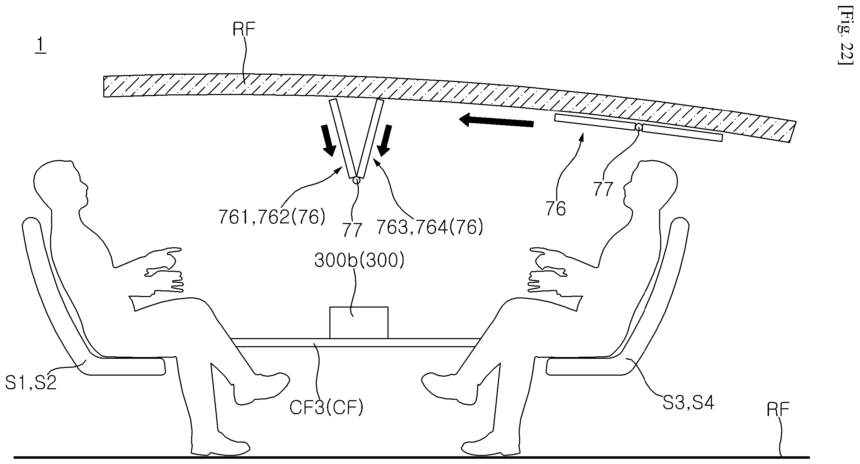

Referring to FIG. 22, passengers in the lounge mode may touch a first icon 60a of the control display panel 60. In response to the touch of the first icon 60a, the first object 300a of the trunk TK may be provided to the passenger space by the transport means (see FIGS. 1 to 3) such as the third part 93. The second object 300b provided to the passenger space before the first object 300a is provided may be returned to the trunk TK (see FIG. 19). For example, the first object 300a may be a game pad. In addition, in response to the touch of the first icon 60a, the display unit 76 may be moved to the center of the top frame RF. At this time, the display unit 76 may output a game screen while folded. Accordingly, the passengers in the lounge mode may enjoy a game by using the game pad and the display unit 76.

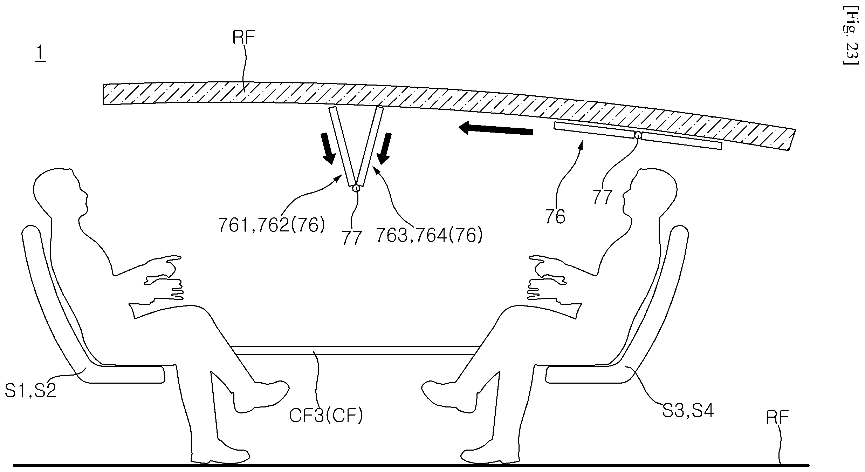

Referring to FIG. 23, the passenger in the lounge mode may touch a video conference icon 61 of the control display panel 60. In response to the touch of the video conference icon 61, the display unit 76 may be moved to the center of the top frame RF. At this time, the display unit 76 may output a video conference screen while folded. Accordingly, the passengers in the lounge mode may hold a video conference with a meeting participant outside the vehicle 1 while facing each other and sharing the same screen through the display unit 76.

Meanwhile, the passenger in the vehicle 1 may stop using the display unit 76. In this case, the display unit 76 may be moved to the rear portion of the top frame RF. At this time, the display unit 76 may be in an unfolded state while the screen is turned off.

Referring to FIGS. 1 to 23, the display device according to an aspect of the present disclosure may include: an elongated plate; a display panel facing downward from the plate, and coupled to the plate to be movable in a longitudinal direction of the plate; and a hinge which crosses a display unit in a direction intersecting with a moving direction of the display panel, wherein the display panel may be foldable around the hinge.

The display panel may include: a first display panel which forms a first portion of the display panel, and which is rotatably coupled to the hinge; and a second display panel which forms a second portion of the display panel, and which is rotatably coupled to the hinge, wherein the first and second display panels may be opposite to each other with respect to the hinge.

The display device may further include: a first carrier which is mounted on the plate, and to which a first side of the display panel is coupled; and a second carrier which is mounted on the plate, and to which a second side of the display panel is coupled, wherein the first and second sides may be opposite to each other with respect to the hinge, and wherein the second carrier is movable toward or away from the first carrier, in the moving direction of the display panel.

The display device may further include: an inner rail which connects the first carrier and the second carrier; and a rack which is elongated along the plate, wherein the first carrier may include: a first motor mounted on the plate; and a first pinion which is fixed to a rotation axis of the first motor, and which is engaged with the rack, wherein the inner rail and the first and second carriers may move together along the rack, when the first motor is operated.

The display device may further include an outer rail which extends along the plate, and which is fixed on the plate, and wherein each of the first carrier and the inner rail includes a pin which protrudes from a side surface of each of the first carrier and the inner rail, wherein the outer rail may include an outer slot into which the pin is movably inserted.

The display device may further include: an inner rail which extends in a moving direction of the second carrier, to which the first carrier is fixed, and to which the second carrier is movably coupled; and a rack which extends along the plate, wherein the second carrier may include: a second motor mounted on the plate; and a second pinion which is fixed to a rotation axis of the second motor, and which is engaged with the rack, wherein the second carrier moves along the rack when the second motor is operated.

The second carrier may further include a pin which protrudes from a side surface of the second carrier, and wherein the inner rail may include an inner slot into which the pin is movably inserted.

The display device further includes a first carrier which is mounted on the plate, and which is movable along the plate; and a pair of second carriers coupled to the first carrier, wherein one of the pair of second carriers may be coupled to a first side of the display panel and the other may be coupled to a second side of the display panel, wherein the first and second sides may be opposite to each other with respect to the hinge, and wherein the pair of second carriers may be movable in a direction closer to or further away from each other in the moving direction of the display panel.

The first carrier may include: a first motor mounted on the plate; and a lead screw which is connected to a rotation axis of the first motor, and which extends in a moving direction of the pair of second carriers, the pair of second carriers may be movable along the lead screw.

The display device may further include a holder connecting the plate and the display panel, wherein the holder may include: a first part coupled to the display panel; and a second part which is coupled to the plate, and to which the first part is rotatably coupled, a rotation center axis of the first part may be parallel to a longitudinal axis of the hinge.

The plate may be curved.

A vehicle may include the display device, and the plate of the display device may be formed on a top of the vehicle.

The vehicle may further include a plurality of objects which are stored in a trunk of the vehicle, and are able to be provided as a passenger space of the vehicle, and a position and folding angle of the display panel may be automatically determined according to a type of object provided as the passenger space.

Certain embodiments or other embodiments of the invention described above are not mutually exclusive or distinct from each other. Any or all elements of the embodiments of the invention described above may be combined or combined with each other in configuration or function.

For example, a configuration "A" described in one embodiment of the invention and the drawings and a configuration "B" described in another embodiment of the invention and the drawings may be combined with each other. Namely, although the combination between the configurations is not directly described, the combination is possible except in the case where it is described that the combination is impossible.

The above detailed description should not be construed as restrictive in all respects and should be considered as illustrative. The scope of the present disclosure should be determined by a reasonable interpretation of the appended claims, and all modifications within the equivalent scope of the present disclosure are included in the scope of the present disclosure.

## Claims

1. A display device comprising:
an elongated plate;
a display panel facing downward from the plate, and coupled to the plate to be movable in a longitudinal direction of the plate; and
a hinge which crosses a display unit in a direction intersecting with a moving direction of the display panel,
wherein the display panel is foldable around the hinge.

2. The display device of claim 1, wherein the display panel comprises:
a first display panel which forms a first portion of the display panel, and which is rotatably coupled to the hinge; and
a second display panel which forms a second portion of the display panel, and which is rotatably coupled to the hinge,
wherein the first and second display panels are opposite to each other with respect to the hinge.

3. The display device of claim 1, further comprising:
a first carrier which is mounted on the plate, and to which a first side of the display panel is coupled; and
a second carrier which is mounted on the plate, and to which a second side of the display panel is coupled,
wherein the first and second sides are opposite to each other with respect to the hinge, and
wherein the second carrier is movable toward or away from the first carrier,
in the moving direction of the display panel.

4. The display device of claim 3, further comprising:
an inner rail which connects the first carrier and the second carrier; and
a rack which is elongated along the plate,
wherein the first carrier comprises:
a first motor mounted on the plate; and
a first pinion which is fixed to a rotation axis of the first motor, and which is engaged with the rack, and
wherein the inner rail and the first and second carriers move together along the rack, when the first motor is operated.

5. The display device of claim 4, further comprising an outer rail which extends along the plate, and which is fixed on the plate, and
wherein each of the first carrier and the inner rail comprises a pin which protrudes from a side surface of each of the first carrier and the inner rail,
wherein the outer rail comprises an outer slot into which the pin is movably inserted.

6. The display device of claim 3, further comprising:
an inner rail which extends in a moving direction of the second carrier, to which the first carrier is fixed, and to which the second carrier is movably coupled; and
a rack which extends along the plate,
wherein the second carrier comprises:
a second motor mounted on the plate; and
a second pinion which is fixed to a rotation axis of the second motor, and which is engaged with the rack,
wherein the second carrier moves along the rack when the second motor is operated.

7. The display device of claim 6, wherein the second carrier further comprises a pin which protrudes from a side surface of the second carrier, and
wherein the inner rail comprises an inner slot into which the pin is movably inserted.

8. The display device of claim 1, further comprising:
a first carrier which is mounted on the plate, and which is movable along the plate; and
a pair of second carriers coupled to the first carrier, wherein one of the pair of second carriers is coupled to a first side of the display panel and the other is coupled to a second side of the display panel, and
wherein the first and second sides are opposite to each other with respect to the hinge, and
wherein the pair of second carriers are movable in a direction closer to or further away from each other in the moving direction of the display panel.

9. The display device of claim 8, wherein the first carrier comprises:
a first motor mounted on the plate; and
a lead screw which is connected to a rotation axis of the first motor, and
which extends in a moving direction of the pair of second carriers,
wherein the pair of second carriers are movable along the lead screw.

10. The display device of claim 1, further comprising a holder connecting the plate and the display panel,
wherein the holder comprises:
a first part coupled to the display panel; and
a second part which is coupled to the plate, and to which the first part is rotatably coupled,
wherein a rotation center axis of the first part is parallel to a longitudinal axis of the hinge.

11. The display device of claim 1, wherein the plate is curved.

12. A vehicle comprising the display device of claim 1,
wherein the plate of the display device is formed on a top of the vehicle.

13. The vehicle of claim 12, further comprising a plurality of objects which are stored in a trunk of the vehicle, and are able to be provided as a passenger space of the vehicle, and
a position and folding angle of the display panel are automatically determined according to a type of object provided as the passenger space.
